# EUROPEAN PATENT APPLICATION

(11) **EP 4 455 210 A1**
(43) Date of publication of application: **30.10.2024**
(21) Application number: 24175339.1
(22) Date of filing: 20.11.2020
(51) Int. Cl.: C08L 67/00, C08L 67/03, C08J 5/18, H05K 1/03

(54) **METHOD FOR PRODUCING LCP FILM FOR CIRCUIT BOARDS, AND LCP FILM FOR CIRCUIT BOARDS MELT EXTRUDED FROM T-DIE**

(30) Priority: 29.11.2019 JP 2019216573
(62) Divisional of application: 20894238.3
(71) Applicant: Denka Company Limited, Tokyo 103-8338 (JP)
(72) Inventor: OGAWA, Naoki, Tokyo (JP); MASUDA, Yusuke, Tokyo (JP)
(74) Representative: Zacco Sweden AB

(57) **Abstract**

An LCP film for a circuit substrate having a low coefficient of linear thermal expansion and excellent dimensional stability, without excessively impairing excellent basic performance possessed by the liquid crystal polyester, such as mechanical characteristics, electrical characteristics, and heat resistance. A method for manufacturing such an LCP film may comprises: a composition provision step of providing an LCP resin composition at least containing 100 parts by mass of a liquid crystal polyester and 1 to 20 parts by mass of a polyarylate; a film forming step; and a pressurizing and heating step of subjecting the T-die melt-extruded LCP film to pressure and heat treatment to obtain an LCP film for a circuit substrate having a coefficient of linear thermal expansion (α2) in the TD direction of 16.8 + 12 ppm/K.

## Description

### Technical Field

The present invention relates to a T-die melt-extruded LCP film for a circuit substrate.

### Background Art

Liquid crystal polymers (LCP) are polymers that exhibit liquid crystallinity in a molten state or a solution state. Especially, thermotropic liquid crystal polymers that exhibit liquid crystallinity in a molten state have excellent properties such as high gas barrier properties, high film strength, high heat resistance, high insulation properties, and low water absorption, and are therefore rapidly coming into practical use in gas barrier film material applications, electronic material applications, and electrically insulating material applications.

As a resin composition containing a liquid crystal polymer, for example, Patent Literature 1 discloses a polymer alloy comprising 45 to 97% by weight of a liquid crystal aromatic polyester and 3 to 55% by weight of an amorphous polyaryl ester (based on the total amount of polyester).

Also, as a resin composition containing a liquid crystal polymer, for example, Patent Literature 2 discloses a polymer alloy comprising 97.1 to 99.0% by weight of a thermoplastic polymer that may form an optically anisotropic molten phase, and 1.0 to 2.9% by weight of an amorphous polymer (based on the total amount of polymer).

Meanwhile, for example, Patent Literature 3 discloses a liquid crystal polymer blended film formed from a blend of a liquid crystal polymer and at least one thermoplastic resin selected from the group consisting of polyethersulfone, polyetherimide, polyamideimide, polyether ether ketone, polyarylate, and polyphenylene sulfide, wherein the proportion of the thermoplastic resin in the blend is 25 to 55% by weight, the coefficient of linear thermal expansion in both the MD and TD directions of the film is 5 to 25 ppm/K, and the coefficient of linear thermal expansion of the thickness direction of the film is less than 270 ppm/K.

### Citation List

### Patent Literature

Patent Literature 1: Japanese Patent Laid-Open No. 06-049338
Patent Literature 2: Japanese Patent Laid-Open No. 2000-290512
Patent Literature 3: Japanese Patent Laid-Open No. 2004-175995

### Summary of Invention

### Technical Problem

The liquid crystal polymer, especially the LCP resin composition containing a liquid crystal polyester, has excellent high frequency characteristics and low dielectric properties, and therefore has been spotlighted in recent years as an insulating material for a circuit substrate such as flexible printed wiring boards (FPC), flexible printed wiring board laminates, and fiber reinforced flexible laminates in the fifth-generation mobile communication system (5G), millimeter wave radar, and the like that will be developed in the future.

Patent Literature 1 discloses that the injection molded plate of the polymer alloy comprising a liquid crystal aromatic polyester and an amorphous polyaryl ester has low anisotropy of mechanical properties. However, the technique of Patent Literature 1 is directed to a molded product having a thickness in the order of millimeters and examines a reduction in the anisotropy of the mechanical properties of the molded product. Thus, the dimensional stability in a thin-film type circuit substrate in the order of micron meters is not examined in Patent Literature 1 at all. In addition, the effect of reducing anisotropy in Patent Literature 1 is 1.7 to 2.4 in a molded product having a thickness of 2 mm, as shown in Examples by the coefficient of anisotropy of the Young's modulus. It is obvious that the coefficient of anisotropy further significantly deteriorates when this technique is applied to the thin-film type circuit substrate in the order of micron meters. Therefore, there is no motivation to apply the technique of Patent Literature 1 to the insulating material for a circuit substrate.

Patent Literature 2 mentions the utility of the LCP resin composition as an electrically insulating material or an electrical circuit substrate material, but actually, an improvement proposal is merely made to improve the mechanical strength (edge tear strength, that is, the strength against defects and tearing which occur in the edge of a film and the like) of an LCP inflation film to 2.5 times or more. Patent Literature 2 lacks an understanding of the anisotropy specific to the T-die melt-extruded LCP film, and the dimensional stability that is required as the insulating material for a circuit substrate is not examined at all.

Meanwhile, in Patent Literature 3, a resin composition made of a liquid crystal polymer and a specific thermoplastic resin is T-die melt-extruded to obtain an LCP blended film, which is then biaxially stretched, thereby obtaining a liquid crystal polymer blended film having low anisotropy of the coefficient of linear thermal expansion in the plane direction (TD direction and MD direction) and a low coefficient of linear thermal expansion in the thickness direction. However, since a large amount of thermoplastic resins such as polyarylate are blended, the liquid crystal polymer blended film obtained has reduced heat resistance, dielectric characteristics, tensile strength, and the like, and lacks in practicality in terms of the basic performance required as the insulating material for a circuit substrate.

The present invention has been made in view of the above problems. An object of the present invention is to provide a method for manufacturing an LCP film for a circuit substrate capable of achieving an LCP film for a circuit substrate having a low coefficient of linear thermal expansion and excellent dimensional stability, without excessively impairing excellent basic performance possessed by the liquid crystal polyester, such as mechanical characteristics, electrical characteristics, and heat resistance.

### Solution to Problem

The present inventors have intensively studied to solve the above problems, and as a result, have found that the coefficient of linear thermal expansion can be reduced by subjecting a T-die melt-extruded LCP film obtained by T-die melt-extruding a predetermined LCP resin composition to pressure and heat treatment, which increases the dimensional stability, and the adhesiveness to a metal foil can also be increased, thereby completing the present invention.

That is, the present invention provides the various specific aspects shown below.
(1) A method for manufacturing an LCP film for a circuit substrate at least comprising: a composition provision step of providing an LCP resin composition at least containing 100 parts by mass of a liquid crystal polyester and 1 to 20 parts by mass of a polyarylate; a film forming step of T-die melt-extruding the LCP resin composition to form a T-die melt-extruded LCP film having a coefficient of linear thermal expansion (α2) in a TD direction of 50 ppm/K or more; and a pressurizing and heating step of subjecting the T-die melt-extruded LCP film to pressure and heat treatment to obtain an LCP film for a circuit substrate having a coefficient of linear thermal expansion (α2) in the TD direction of 16.8 ± 12 ppm/K.
(2) The method for manufacturing an LCP film for a circuit substrate according to (1), wherein the T-die melt-extruded LCP film has a ratio of a Young's modulus in an MD direction Y_{MD} to a Young's modulus in the TD direction Y_{TD} (Y_{MD}/Y_{TD}) of 2 or more and 10 or less, and in the pressurizing and heating step, the T-die melt-extruded LCP film is subjected to pressure and heat treatment to obtain an LCP film for a circuit substrate having a ratio of the Young's modulus in the MD direction Y_{MD} to the Young's modulus in the TD direction Y_{TD} (Y_{MD}/Y_{TD}) of 0.8 or more and 1.5 or less.
(3) The method for manufacturing an LCP film for a circuit substrate according to (1) or (2), wherein the T-die melt-extruded LCP film has a thickness of 10 µm or more and 500 µm or less.
(4) The method for manufacturing an LCP film for a circuit substrate according to any one of (1) to (3), wherein in the pressurizing and heating step, the T-die melt-extruded LCP film is subjected to thermocompression bonding while being sandwiched between a pair of endless belts of a double belt press.
(5) The method for manufacturing an LCP film for a circuit substrate according to (4), wherein in the pressurizing and heating step, the T-die melt-extruded LCP film is subjected to pressure and heat treatment under the conditions of a surface pressure of 0.5 to 10 MPa and a heating and pressurizing time of 250 to 430°C.
(6) The method for manufacturing an LCP film for a circuit substrate according to any one of (1) to (5), wherein the LCP film for a circuit substrate has a thickness of 10 µm or more and 500 µm or less.
(7) The method for manufacturing an LCP film for a circuit substrate according to any one of (1) to (6), wherein the LCP film for a circuit substrate has dielectric characteristics (36 GHz) of a relative dielectric constant εᵣ of 3.0 to 3.9 and a dielectric loss tangent tanδ of 0.0005 to 0.003.
(8) A T-die melt-extruded LCP film for a circuit substrate, comprising at least 100 parts by mass of a liquid crystal polyester and 1 to 20 parts by mass of a polyarylate, the film having a coefficient of linear thermal expansion (α2) in a TD direction of 16.8 ± 12 ppm/K, and a thickness of 10 µm or more and 500 µm or less.
(9) The T-die melt-extruded LCP film for a circuit substrate according to (8), wherein a ratio of a Young's modulus in an MD direction Y_{MD} to a Young's modulus in the TD direction Y_{TD} (Y_{MD}/Y_{TD}) is 0.8 or more and 1.5 or less.
(10) The T-die melt-extruded LCP film for a circuit substrate according to (8) or (9), wherein the film has dielectric characteristics (36 GHz) of a relative dielectric constant εᵣ of 3.0 to 3.9 and a dielectric loss tangent tanδ of 0.0005 to 0.003.

### Advantageous Effects of Invention

The present invention can provide a method for manufacturing an LCP film for a circuit substrate having a low coefficient of linear thermal expansion and increased dimensional stability, without excessively impairing excellent basic performance possessed by the liquid crystal polyester, such as mechanical characteristics, electrical characteristics, high frequency characteristics, and heat resistance, and the method is excellent in productivity and cost efficiency. In addition, the present invention can provide an LCP film for a circuit substrate (a T-die melt-extruded LCP film for a circuit substrate) easily and stably with good reproducibility, and the film is not only excellent in basic performance such as mechanical characteristics, electrical characteristics, high frequency characteristics, and heat resistance, but also has a low anisotropy in the film in-plane direction, and can increase the adhesiveness to a metal foil.

### Brief Description of Drawings

[Figure 1] Figure 1 is a flow chart of a method for manufacturing an LCP film for a circuit substrate 11 of one embodiment.
[Figure 2] Figure 2 is a schematic view of the LCP film for a circuit substrate 11 of one embodiment.
[Figure 3] Figure 3 is a schematic view of a metal foil-clad laminate 31 of one embodiment.

### Description of Embodiments

Hereinafter, the embodiments of the present invention will be described in detail with reference to the drawings. Unless otherwise indicated, the positional relationship, such as top, bottom, left, and right is based on the positional relationship shown in the drawings. Also, the dimensional ratios of the drawings are not limited to those illustrated in the drawings. It should be noted that the following embodiments are merely examples for explaining the present invention, and the present invention is not limited thereto. That is, the present invention can be appropriately modified and implemented within a range not departing from the gist of the present invention. As used herein, for example, the description of the numerical value range "1 to 100" includes both the lower limit value "1" and the upper limit value "100". Also, the same applies to the description of other numerical value ranges.

### (LCP Film)

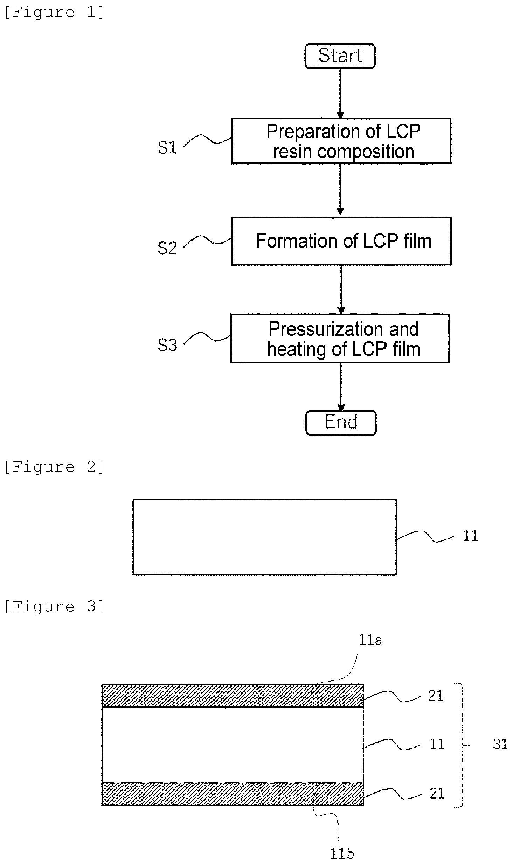

Figure 1 is a flow chart of a method for manufacturing an LCP film for a circuit substrate 11 of the present embodiment, and Figure 2 is a schematic view of the LCP film for a circuit substrate 11 of the present embodiment.

The method for manufacturing the present embodiment comprises at least a composition preparing step (S1) of preparing a predetermined LCP resin composition, a film forming step (S2) of T-die melt-extruding the LCP resin composition to form a predetermined T-die melt-extruded LCP film, and a pressurizing and heating step (S3) of subjecting the T-die melt-extruded LCP film to pressure and heat treatment to obtain a predetermined LCP film for a circuit substrate 11.

### <Composition Provision Step (S1)>

In the composition provision step (S1), an LCP resin composition at least containing 100 parts by mass of a liquid crystal polyester as the liquid crystal polymer and 1 to 20 parts by mass of a polyarylate is provided.

As the liquid crystal polyester, those known in the art may be used, and the type thereof is not particularly limited. A liquid crystal polyester that exhibits thermotropic liquid crystalline properties and has a melting point of 250°C or more, and preferably a melting point of 280°C to 380°C is preferably used. As such a liquid crystal polyester, aromatic polyesters that are synthesized from monomers such as aromatic diols, aromatic carboxylic acids, and hydroxycarboxylic acids, and that exhibit liquid crystallinity during melting are known. Representative examples thereof include, but are not particularly limited to, a polycondensate of ethylene terephthalate and para-hydroxybenzoic acid, a polycondensate of phenolic and phthalic acids and para-hydroxybenzoic acid, and a polycondensate of 2,6-hydroxynaphthoic acid and para-hydroxybenzoic acid. The liquid crystal polyesters can be used singly or in any combination of two or more thereof at any ratio.

Among the liquid crystal polyesters, an aromatic polyester-based liquid crystal polymer at least having 6-hydroxy-2-naphthoic acid and a derivative thereof (hereinafter, simply referred to as "monomer component A") which is a basic structure, and at least one selected from the group consisting of para-hydroxybenzoic acid, terephthalic acid, isophthalic acid, 6-naphthalenedicarboxylic acid, 4,4'-biphenol, bisphenol A, hydroquinone, 4,4-dihydroxybiphenol, ethylene terephthalate and derivatives thereof (hereinafter, simply referred to as "monomer component B") as the monomer component is preferred from the viewpoint of excellent basic performance such as mechanical characteristics, electrical characteristics, and heat resistance.

The aromatic polyester-based liquid crystal polymer containing the monomer component A and the monomer component B described above forms an anisotropic molten phase in which linear chains of molecules are regularly aligned in a molten state, typically exhibits thermotropic liquid crystalline properties, and has excellent basic performance such as mechanical characteristics, electrical characteristics, high frequency characteristics, heat resistance, and hygroscopicity. The properties of the anisotropic molten phase of the aromatic polyester-based liquid crystal polymer described above can be confirmed by a known method such as a polarization test method using crossed polarizers. More specifically, the anisotropic molten phase can be confirmed by observing a sample placed on a Leitz hot stage with a Leitz polarization microscope under a nitrogen atmosphere at 40-fold magnification.

The aromatic polyester-based liquid crystal polymer described above may employ any constitution as long as it has the monomer component A and the monomer component B as essential units. For example, it may have two or more monomer components A, or three or more monomer components A. The aromatic polyester-based liquid crystal polymer described above may contain other monomer components other than the monomer component A and the monomer component B. That is, the aromatic polyester-based liquid crystal polymer may be a binary or higher polycondensate consisting of only the monomer component A and the monomer component B, or may be a ternary or higher polycondensate consisting of the monomer component A, the monomer component B, and other monomer components. Other monomer components (hereinafter, also simply referred to as the "monomer component C") are other than the monomer component A and the monomer component B described above, and specific examples thereof include aromatic or aliphatic dihydroxy compounds and derivatives thereof; aromatic or aliphatic dicarboxylic acid and derivatives thereof; aromatic hydroxycarboxylic acid and derivatives thereof; aromatic diamine, aromatic hydroxyamine, or aromatic aminocarboxylic acid and derivatives thereof, but are not particularly limited thereto.

As used herein, the "derivatives" means those which have a modifying group such as a halogen atom (e.g., a fluorine atom, a chlorine atom, a bromine atom, and a iodine atom), an alkyl group having 1 to 5 carbon atoms (e.g., a methyl group, an ethyl group, an n-propyl group, an isopropyl group, an n-butyl group, an isobutyl group, an s-butyl group, and a t-butyl group), an aryl group such as a phenyl group, a hydroxyl group, an alkoxy group having 1 to 5 carbon atoms (e.g., a methoxy group and an ethoxy group), a carbonyl group, -O-, -S-, and -CH₂-introduced in a part of the monomer components described above (hereinafter, also referred to as "monomer component having a substituent"). Here, the "derivatives" may be acylated products, ester derivatives, or ester forming monomers such as acid halides, of the monomer components A and B, which may have a modifying group described above.

Examples of the more preferred aromatic polyester-based liquid crystal polymer include a binary polycondensate of para-hydroxybenzoic acid and derivatives thereof, and 6-hydroxy-2-naphthoic acid and derivatives thereof; a ternary or higher polycondensate of para-hydroxybenzoic acid and derivatives thereof, 6-hydroxy-2-naphthoic acid and derivatives thereof, and the monomer component C; a ternary or higher polycondensate of para-hydroxybenzoic acid and derivatives thereof, 6-hydroxy-2-naphthoic acid and derivatives thereof, and at least one selected from the group consisting of terephthalic acid, isophthalic acid, 6-naphthalenedicarboxylic acid, 4,4'-biphenol, bisphenol A, hydroquinone, 4,4-dihydroxybiphenol, ethylene terephthalate, and derivatives thereof; a quaternary or higher polycondensate of para-hydroxybenzoic acid and derivatives thereof, 6-hydroxy-2-naphthoic acid and derivatives thereof, at least one selected from the group consisting of terephthalic acid, isophthalic acid, 6-naphthalenedicarboxylic acid, 4,4'-biphenol, bisphenol A, hydroquinone, 4,4-dihydroxybiphenol, ethylene terephthalate, and derivatives thereof, and one or more monomer components C. These can be obtained as the aromatic polyester-based liquid crystal polymer having a relatively low melting point as compared with, for example, a homopolymer of para-hydroxybenzoic acid, and thus, LCP films using these polymers have excellent fabricability in the thermocompression bonding to an adherend.

From the viewpoint of reducing the melting point of the aromatic polyester-based liquid crystal polymer, increasing the fabricability of the LCP film in the thermocompression bonding to an adherend, obtaining high peel strength when the LCP film is thermocompression bonded to a metal foil, or the like, the content in terms of molar ratio of the monomer component A to the aromatic polyester-based liquid crystal polymer is preferably 10 mol% or more and 70 mol% or less, more preferably 10 mol% or more and 50 mol% or less, further preferably 10 mol% or more and 40 mol% or less, and still more preferably 15 mol% or more and 30 mol% or less. Similarly, the content in terms of molar ratio of the monomer component B to the aromatic polyester-based liquid crystal polymer is preferably 30 mol% or more and 90 mol% or less, more preferably 50 mol% or more and 90 mol% or less, further preferably 60 mol% or more and 90 mol% or less, and still more preferably 70 mol% or more and 85 mol% or less.

The content of the monomer component C that may be contained in the aromatic polyester-based liquid crystal polymer is preferably 10% by mass or less, more preferably 8% by mass or less, further preferably 5% by mass or less, and preferably 3% by mass or less in terms of molar ratio.

A known method may be applied to the synthetic method of the liquid crystal polyester without particular limitation. A known polycondensation method to form ester bonds by the monomer components described above, such as melt polymerization, a melt acidolysis method, and a slurry polymerization method can be applied. When these polymerization methods are applied, an acylation or acetylation step may be performed in accordance with a conventional method.

The LCP resin composition of the present embodiment further contains a polyarylate, in addition to the liquid crystal polyester described above. By containing a polyarylate which is an amorphous polymer, the anisotropy of the LCP film produced in the film forming step (S2) in the film in-plane direction can be effectively reduced because compatibilization with the liquid crystal polyester is facilitated and so on in the pressurizing and heating step (S3). The polyarylate may be appropriately selected from known ones and used, and the type thereof is not particularly limited. For example, an amorphous polyestercarbonate constituted by an aromatic dicarboxylic acid unit such as isophthalic acid, terephthalic acid, a mixture thereof and a diphenol unit such as bisphenol is preferred. As the commercial product of polyarylate, for example, U polymer (registered trademark) manufactured by UNITIKA LTD., Durel (registered trademark) manufactured by Celanese Corporation of the United States, and the like are known. Polyarylates can be used singly or in any combination of two or more thereof at any ratio.

The total content of the polyarylate described above can be appropriately set depending on the desired performance, and is preferably 1 to 20 parts by mass, more preferably 1 to 17 parts by mass, further preferably 1 to 15 parts by mass, and particularly preferably 2 to 15 parts by mass per 100 parts by mass of the liquid crystal polyester in terms of solid content, but is not particularly limited thereto. With the content of polyarylate within the above preferred range, the effect of reducing the anisotropy in the film in-plane direction of the LCP film tends to be effectively exhibited. When the content of polyarylate exceeds the above preferred range, the content of the liquid crystal polyester is relatively reduced, and the basic performance such as mechanical characteristics, electrical characteristics, high frequency characteristics, and heat resistance as well as the effect of reducing the anisotropy by the present invention tend to be reduced. Especially when the content of polyarylate is large, the electrical characteristics of the LCP film for a circuit substrate 11 to be obtained tend to be significantly reduced, for example, a dielectric loss tangent tanδ (36 GHz) may exceed 0.003. Thus, from the viewpoint of achieving the LCP film for a circuit substrate 11 having low anisotropy while ensuring electrical characteristics as a circuit substrate application, the total content of polyarylate is preferably 1 to 10 parts by mass, more preferably 1 to 7 parts by mass, further preferably 1 to 5 parts by mass, and particularly preferably 2 to 4 parts by mass per 100 parts by mass of the liquid crystal polyester in terms of solid content. In any case, the content of polyarylate may be adjusted in consideration of the balance between the effect of reducing anisotropy by the present invention and the reduction in basic performance of the liquid crystal polyester. The total content of liquid crystal polyester can be appropriately set depending on the desired performance, and is preferably 80 to 99% by mass, more preferably 83 to 99% by mass, further preferably 85 to 99% by mass, and particularly preferably 85 to 98% by mass based on the total resin solid content of the resin composition, but is not particularly limited thereto.

In addition to the components described above, the LCP resin composition of the present embodiment may contain additives known in the art, for example, release improving agents such as higher fatty acids having 10 to 25 carbon atoms, higher fatty acid esters, higher fatty acid amide, higher fatty acid metal salts, polysiloxane, and fluorine resins; colorants such as dyes, pigments, and carbon black; organic fillers; inorganic fillers; antioxidants; thermal stabilizers; light stabilizers; ultraviolet absorbers; flame retardants; lubricants; antistatic agents; surfactants; anticorrosives; foaming agents; defoaming agents; and fluorescent agents, within a range not excessively impairing the effects of the present invention. These additives can be contained in the molten resin composition during film formation of the LCP film. These additives can be used each one alone or in combination of two or more. The content of the additive is not particularly limited, but is preferably 0.01 to 10% by mass, more preferably 0.1 to 7% by mass, and further preferably 0.5 to 5% by mass, based on a total amount of the LCP film, from the viewpoint of fabricability, thermal stability, and the like.

The LCP resin composition of the present embodiment may be prepared in accordance with a conventional method, and is not particularly limited. The components described above can be manufactured and processed by a known method such as kneading, melt-kneading, granulation, extrusion, and pressing or injection molding. When melt-kneading is performed, commonly used uniaxial or biaxial extruders or kneading apparatuses such as various kneaders can be used. When various components are supplied to these melt-kneading apparatuses, the liquid crystal polyester, the polymer material, and the like may be dry blended in advance with a mixing apparatus such as a tumbler and a Henschel mixer. Upon melt-kneading, the cylinder set temperature of the kneading apparatus may be appropriately set without particular limitation, and is typically preferably within a range of the melting point of the liquid crystal polyester or more and 360°C or less, and more preferably the melting point of the liquid crystal polyester +10°C or more and 360°C or less.

### <Film Forming Step (S2)>

In the film forming step (S2), the LCP resin composition described above is formed into a film by a melt extrusion film-forming method using a T-die (hereinafter, simply referred to as "T-die melt-extruded") to form a T-die melt-extruded LCP film having a coefficient of linear thermal expansion (α2) in the TD direction of 50 ppm/K or more. As used herein, to observe a value from which the thermal history has been eliminated, the coefficient of linear thermal expansion refers to a value obtained when the LCP film or the LCP film for a circuit substrate 11 is heated at a temperature rising rate of 5°C/min (1st heating), cooled to the measurement environment temperature (23°C) (1st cooling), and then heated for the second time at a temperature rising rate of 5°C/min (2nd heating). Others are in accordance with the measurement conditions described in the Examples below.

Specifically, the T-die melt-extruded LCP film can be obtained, for example, by melt-kneading the LCP resin composition described above with an extruder and extruding the molten resin through a T-die. At this time, it is also possible to dry blend various components in advance, without going through the melt-kneading process, and to knead the components during the operation of melt extrusion, thereby preparing the LCP resin composition and obtaining the T-die melt-extruded LCP film as it is. The set conditions of the extruder upon forming a film as mentioned above may be appropriately set depending on the type and composition of the LCP resin composition to be used, the desired performance of the intended LCP film, and the like, and typically, the set temperature of the cylinder of the extruder is preferably 230 to 360°C, and more preferably 280 to 350°C, but is not particularly limited thereto. Also, for example, the slit clearance of the T-die may be appropriately set depending on the type and composition of the LCP resin composition to be used, the desired performance of the intended LCP film, and the like, and typically preferably 0.1 to 1.5 mm, and more preferably 0.1 to 0.5 mm, but is not particularly limited thereto.

The thickness of the T-die melt-extruded LCP film to be obtained can be appropriately set depending on the desired performance, and is not particularly limited. Considering the handleability and the productivity during T-die melt extrusion and the like, the thickness is preferably 10 µm or more and 500 µm or less, more preferably 20 µm or more and 300 µm or less, and further preferably 30 µm or more and 250 µm or less.

The melting point (melting temperature) of the T-die melt-extruded LCP film is not particularly limited, but the melting point (melting temperature) is preferably 200 to 400°C from the viewpoint of the heat resistance, processability, and the like of the film, and is preferably 250 to 360°C, more preferably 260 to 355°C, further preferably 270 to 350°C, and particularly preferably 275 to 345°C from the viewpoint of especially increasing the thermocompression bonding properties to the metal foil. As used herein, to observe a value from which the thermal history has been eliminated, the melting point of the T-die melt-extruded LCP film refers to a melting peak temperature in differential scanning calorimetry (DSC) when an LCP film to be subjected to pressure bonding is heated at a temperature rising rate of 20°C/min (1st heating), cooled at a temperature decreasing rate of 50°C/min (1st cooling), and then heated for the second time at a temperature rising rate of 20°C/min (2nd heating). Others are in accordance with the measurement conditions described in the Examples below.

When the above LCP resin composition is T-die melt-extruded, typically, a T-die melt-extruded LCP film having a coefficient of linear thermal expansion (CTE, α2) in the MD direction (Machine Direction) of -40 to 40 ppm/K and a coefficient of linear thermal expansion (CTE, α2) in the TD direction (Transverse Direction of 50 to 120 ppm/K is likely to be obtained. When the above LCP resin composition is T-die melt-extruded, typically, a T-die melt-extruded LCP film having a ratio of the Young's modulus in the MD direction Y_{MD} to the Young's modulus in the TD direction Y_{TD} (Y_{MD}/Y_{TD}) of 2 or more and 10 or less is likely to be obtained. The reason why such physical properties can be obtained is that the main chain of the liquid crystal polyester tends to be likely aligned in the MD direction during T-die melt-extrusion and the anisotropic melt phase of the liquid crystal polyester is present during T-die melt-extrusion.

Thus, in the film forming step (S2), a T-die melt-extruded LCP film with a high degree of alignment (high anisotropy) is likely to be formed. In the present invention, even such a T-die melt-extruded LCP film having a high degree of alignment can significantly reduce its alignment (anisotropy) by being subjected to the pressurizing and heating step (S3) using the LCP resin composition having the above composition. Therefore, a feature of the present invention is that the T-die melt-extruded LCP film having a high degree of alignment, which has conventionally been considered to have poor industrial applicability, can be utilized as the half-finished product (intermediate product). Thus, when the T-die melt-extruded LCP film with a significantly high degree of alignment (significantly high anisotropy) is utilized, the effects of the present invention tend to be more prominent. The coefficient of linear thermal expansion (CTE, α2) of the T-die melt-extruded LCP film in the MD direction is not particularly limited, but is preferably -40 to 0 ppm/K, and more preferably -30 to 0 ppm/K. The coefficient of linear thermal expansion (CTE, α2) of the LCP film in the TD direction is not particularly limited, but is preferably 50 to 120 ppm/K, and more preferably 50 to 100 ppm/K. Further, the ratio of the Young's modulus in the MD direction Y_{MD} to the Young's modulus in the TD direction Y_{TD} (Y_{MD}/Y_{TD}) of the LCP film to be obtained is not particularly limited, but is preferably 2 to 9, and more preferably 3 to 8.

### <Pressurizing and Heating Step (S3)>

In the pressurizing and heating step (S3), the T-die melt-extruded LCP film with a high degree of alignment (high anisotropy) described above is subjected to pressure and heat treatment to reduce its degree of alignment (anisotropy) to obtain the LCP film for a circuit substrate 11 having a coefficient of linear thermal expansion (CTE, α2) in the TD direction of 16.8 ± 12 ppm/K. By pressurizing and heating, the alignment of the polymer chain of the liquid crystal polyester is relaxed and the film dimensional stability is improved in advance, so that the adhesiveness to a metal foil can be excellent.

The heating and pressurizing treatment may be performed using a method known in the art such as contact type heat treatment and non-contact type heat treatment, and the type thereof is not particularly limited. Heat setting can be carried out using a known device such as a non-contact heater, an oven, a blowing apparatus, a heat roller, a cooling roller, a heat press, or a double belt heat press. At this time, heat treatment may be performed by placing a release film or a porous film known in the art on a surface of the LCP film, if necessary. When this heat treatment is performed, thermocompression molding in which a release film or a porous film is placed on both surfaces of the LCP film, which is subjected to thermocompression bonding by sandwiching it between a pair of endless belts of a double belt press, and then the release film or the porous film is removed is preferably used, from the viewpoint of controlling the alignment. Thermocompression molding may be performed with reference to, for example, Japanese Patent Laid-Open No. 2010-221694. The treatment temperature when the T-die melt-extruded LCP film using the above LCP resin composition is subjected to thermocompression molding between a pair of endless belts of a double belt press is preferably a temperature higher than the melting point of the liquid crystal polyester and not more than a temperature 70°C higher than the melting point, more preferably not less than a temperature +5°C higher than the melting point and not more than a temperature 60°C higher than the melting point, and further preferably not less than a temperature +10°C higher than the melting point and not more than a temperature 50°C higher than the melting point, to control the crystalline state of the T-die melt-extruded LCP film. The thermocompression bonding conditions at this time can be appropriately set depending on the desired performance, and thermocompression bonding is preferably performed under the conditions of a surface pressure of 0.5 to 10 MPa and a heating and pressurizing time of 250 to 430°C, more preferably under the conditions of a surface pressure of 0.6 to 8 MPa and a heating and pressurizing time of 260 to 400°C, and further preferably under the conditions of a surface pressure of 0.7 to 6 MPa and a heating and pressurizing time of 270 to 370°C, but is not particularly limited thereto. On the other hand, when a non-contact heater or an oven is used, for example, thermocompression bonding is preferably performed under the conditions at 200 to 320°C for 1 to 20 hours.

### (LCP Film for Circuit Substrate)

The thickness of the LCP film for a circuit substrate 11 obtained after the treatment in the pressurizing and heating step (S3) can be appropriately set depending on the desired performance, and is not particularly limited. Considering the handleability, the productivity, and the like during the pressure and heat treatment, the thickness is preferably 10 µm or more and 500 µm or less, more preferably 20 µm or more and 300 µm or less, and further preferably 30 µm or more and 250 µm or less.

The coefficient of linear thermal expansion (CTE, α2) of the LCP film for a circuit substrate 11 in the TD direction is not particularly limited, but is preferably 16.8 ± 12 ppm/K, more preferably 16.8 ± 10 ppm/K, and further preferably 16.8 ± 8 ppm/K from the viewpoint of increasing the adhesiveness to a metal foil. The present invention has a significant effect in that the coefficient of linear thermal expansion (CTE, α2) in the TD direction can be significantly reduced although the T-die melt-extruded LCP film with high anisotropy that has a coefficient of linear thermal expansion (CTE, α2) in the TD direction of 50 ppm/K or more is used as the treatment target from the beginning. From the viewpoint of increasing the adhesiveness to an electrolytic copper foil, the coefficient of linear thermal expansion (CTE, α2) in the TD direction is preferably 16.0 ppm/K or more and 25.0 ppm/K or less, more preferably 16.0 ppm/K or more and 23.0 ppm/K or less, and further preferably 16.8 ppm/K or more and 21.0 ppm/K or less, in one aspect of the LCP film for a circuit substrate 11.

The coefficient of linear thermal expansion (CTE, α2) of the LCP film for a circuit substrate 11 in the MD direction is not particularly limited, but is preferably 0 to 40 ppm/K, more preferably 0 to 30 ppm/K, and further preferably 0 to 20 ppm/K, from the viewpoint of increasing the adhesiveness to a metal foil. The coefficient of linear thermal expansion (CTE, α2) in the film thickness direction is not particularly limited, but is preferably 150 ppm/K or less.

On the other hand, the ratio of the Young's modulus in the MD direction Y_{MD} to the Young's modulus in the TD direction Y_{TD} (Y_{MD}/Y_{TD}) of the LCP film for a circuit substrate 11 is preferably 0.8 or more and 1.5 or less, more preferably 0.9 or more and 1.4 or less, further preferably 0.9 or more and 1.3 or less, and particularly preferably 0.95 or more and 1.2 or less, from the viewpoint of reducing the anisotropy in the film in-plane direction.

The dielectric characteristics of the LCP film for a circuit substrate 11 can be appropriately set depending on the desired performance, and is not particularly limited. From the viewpoint of obtaining higher dielectric characteristics, the relative dielectric constant εᵣ is preferably 3.0 to 3.9, and more preferably 3.0 to 3.6. The dielectric loss tangent tanδ (36 GHz) is preferably 0.0005 to 0.0030, and more preferably 0.0005 to 0.0025.

The melting point (melting temperature) of the LCP film for a circuit substrate 11 is not particularly limited, but the melting point (melting temperature) is preferably 200 to 400°C from the viewpoint of the heat resistance, processability, and the like of the film, and is preferably 250 to 360°C, more preferably 260 to 355°C, further preferably 270 to 350°C, and particularly preferably 275 to 345°C from the viewpoint of increasing especially the thermocompression bonding properties to the metal foil. As used herein, the melting point of the LCP film for a circuit substrate 11 refers to a value measured under the same measurement conditions as the melting point of the above LCP film.

### (Metal Foil-Clad Laminate)

Figure 3 is a schematic view of a metal foil-clad laminate 31 of the present embodiment. The metal foil-clad laminate 31 (metal foil-laminated LCP film) of the present embodiment includes the LCP film for a circuit substrate 11 described above, and one or more metal foils 21 provided on at least one surface of this LCP film for a circuit substrate 11. As used herein, "provided on one (another) surface side of" is a concept which encompasses not only an aspect in which the metal foil 21 is provided only on one surface 11a of the LCP film for a circuit 11, but also an aspect in which the metal foil 21 is provided another surface 11b of the LCP film for a circuit 11 and an aspect in which the metal foils 21 are provided on both surfaces 11a and 11b of the LCP film for a circuit 11.

Examples of the metal foil 21 include, but are not particularly limited to, gold, silver, copper, copper alloy, nickel, nickel alloy, aluminum, aluminum alloy, iron, and iron alloy. Among these, a copper foil, an aluminum foil, a stainless steel foil, and an alloy foil of copper and aluminum are preferred, and a copper foil is more preferred. As such a copper foil, any one manufactured by a rolling method, an electrolysis method, or the like may be used, and electrolytic copper foil and rolled copper foil which have a relatively high surface roughness are preferred. The thickness of the metal foil 21 may be appropriately set in accordance with the desired performance, and is not particularly limited. Typically, the thickness is preferably 1.5 to 1,000 µm, more preferably 2 to 500 µm, further preferably 5 to 150 µm, and particularly preferably 7 to 100 µm. As long as the function and effect of the present invention are not impaired, the metal foil 21 may be subjected to surface treatment such as chemical surface treatment such as acid washing.

The method for providing a metal foil 21 on the surfaces 11a and 11b of the LCP film for a circuit 11 can be performed in accordance with a conventional method, and is not particularly limited. The method may be any one of methods in which a metal foil 21 is laminated on the LCP film for a circuit 11 and then both layers are adhered or pressure bonded, physical methods (dry method) such as sputtering and vapor deposition, chemical methods (wet method) such as electroless plating and electrolytic plating after electroless plating, and methods for applying a metal paste.

Examples of the preferred laminating method include a method in which an LCP film for a circuit 11 and a metal foil 21 are stacked into a laminate having the metal foil 21 placed on the LCP film for a circuit 11, and this laminate is subjected to thermocompression molding while sandwiching the laminate between a pair of endless belts of a double belt press. As described above, the LCP film for a circuit substrate 11 used in the present embodiment has a significantly reduced coefficient of linear thermal expansion (CTE, α2) in the TD direction, and in a preferred aspect, has sufficiently reduced anisotropy between the Young's modulus in the MD direction Y_{MD} and the Young's modulus in the TD direction Y_{TD} without excessively impairing excellent basic performance possessed by the liquid crystal polyester, so that the LCP film for a circuit substrate 11 can obtain higher peel strength to the metal foil 21 as compared with conventional films. Therefore, the process tolerance in the manufacture of a circuit substrate or the metal foil-clad laminate 31 can be increased, and the productivity and cost efficiency can also be increased.

The temperature during thermocompression bonding of the metal foil 21 can be appropriately set depending on the desired performance, and is preferably not less than a temperature 50°C lower than the melting point of the liquid crystal polyester and not more than the melting point, more preferably not less than a temperature 40°C lower than the melting point and not more than the melting point, further preferably not less than a temperature 30°C lower than the melting point and not more than the melting point, and particularly preferably not less than a temperature 20°C lower than the melting point and not more than the melting point, but is not particularly limited thereto. The temperature during thermocompression bonding of the metal foil 21 is a value measured with the surface temperature of the LCP film of the above-described laminate. The thermocompression bonding conditions at this time can be appropriately set in accordance with the desired performance, but is not particularly limited thereto. For example, when a double belt press is used, the thermocompression bonding is preferably performed under the conditions of surface pressure of 0.5 to 10 MPa and a heating time of 200 to 360°C.

The metal foil-clad laminate 31 of the present embodiment may have a further laminated structure, as long as including a thermocompression-bonded body having a two layer structure of the LCP film for a circuit substrate 11 and the metal foil 21. The laminated structure may be a multilayer structure at least having the two layer structure described above, for example, a two layer structure such as metal foil 21/LCP film for a circuit substrate 11; a three layer structure such as metal foil 21/LCP film for a circuit substrate 11/metal foil 21 or LCP film for a circuit substrate 11/metal foil 21/LCP film for a circuit substrate 11; or a five layer structure such as metal foil 21/LCP film for a circuit substrate 11/metal foil 21/LCP film for a circuit substrate 11/metal foil 21. Also, a plurality of metal foil-clad laminates 31 (e.g., 2 to 50 laminates) may be laminated and thermocompression bonded.

In the metal foil-clad laminate 31 of the present embodiment, the peel strength between the LCP film for a circuit 11 and the metal foil 21 is not particularly limited, but is preferably 1.0 (N/mm) or more, more preferably 1.1 (N/mm) or more, and further preferably 1.2 (N/mm) or more, from the viewpoint of providing further high peel strength. As described above, since the metal foil-clad laminate 31 of the present embodiment can realize higher peel strength than the conventional technique, for example, peeling between the LCP film for a circuit 11 and the metal foil 21 can be suppressed in the heating step during manufacture of a substrate. In addition, since mild manufacturing conditions can be applied to obtain the same peel strength as the conventional technique, the deterioration of the basic performance possessed by the liquid crystal polyester can be suppressed, while maintaining the same degree of peel strength as the conventional metal foil-clad laminate 31.

The metal foil-clad laminate 31 of the present embodiment can be used as a raw material for electronic circuit substrates, multilayer substrates, or the like, by performing pattern etching on at least a part of the metal foil 21, and can be used in applications such as high heat radiation substrates, antenna substrates, optoelectronic hybrid substrates, and IC packages. In addition, since having excellent high frequency characteristics and low dielectric properties, having excellent adhesiveness between the LCP film for a circuit 11 and the metal foil 21, and having good dimensional stability, the metal foil-clad laminate 31 of the present embodiment is an especially useful raw material as an insulating material for flexible printed wiring boards (FPC) and the like in the fifth-generation mobile communication system (5G), millimeter wave radar, and the like.

### Examples

The feature of the present invention will be further described in detail below by way of Examples and Comparative Examples, but the present invention is not limited thereto in any way. That is, the materials, amounts used, proportions, contents of treatment, treatment procedures, and the like presented in the following Examples can be appropriately modified without departing from the gist of the present invention. The values of various manufacturing conditions and evaluation results in the following Examples have a meaning as a preferred upper limit value or a preferred lower limit value in the embodiment of the present invention, and the preferred numerical value range may be a range defined by a combination of the upper limit value or the lower limit value and the values of the following Examples or a combination of values in Examples.

### (Examples 1 to 3)

### Synthesis of LCP

A reaction vessel equipped with a stirrer and a vacuum distillation apparatus was charged with p-hydroxybenzoic acid (74 mol%), 6-hydroxy-2-naphthoic acid (26 mol%), and 1.025-fold molar amount of acetic anhydride relative to the total monomer amount, and the reaction vessel was warmed to 150°C under a nitrogen atmosphere and held for 30 minutes, and then immediately warmed to 190°C while distilling off the byproduct acetic acid and held for 1 hour to obtain an acetylated reaction product. The obtained acetylated reaction product was warmed to 320°C over 3.5 hours, then the pressure was reduced to 2.7 kPa over about 30 minutes to perform melt polycondensation, and the pressure was gradually returned to ordinary pressure to obtain a polymer solid. The obtained polymer solid was ground and granulated at 300°C with a biaxial extruder to obtain LCP pellets of an aromatic polyester-based liquid crystal polymer consisting of p-hydroxybenzoic acid and 6-hydroxy-2-naphthoic acid (molar ratio 74:26).

### Preparation of LCP Resin Composition

Each of the obtained LCP pellet and polyarylate (product name: U polymer POWDER CK, manufactured by UNITIKA LTD.) (PAR) was supplied in the proportions shown in Table 1, and mixed, reacted, and granulated with a biaxial extruder at 300°C to obtain each of the LCP resin composition pellets of Examples 1 to 3.

### Manufacture of LCP Film

Each of the obtained LCP resin composition pellets of Examples 1 to 3 was used and formed into a film by T-die casting at 300°C to obtain each of the LCP melt-extruded films of Examples 1 to 3 having a melting temperature of 280°C and a thickness of 50 µm.

### Manufacture of Pressure and Heat Treated LCP Film

Each of the obtained LCP melt-extruded films of Examples 1 to 3 was subjected to contact type heat treatment at 320°C for 30 seconds with a double belt heat press to obtain each of the pressure and heat treated LCP films of Examples 1 to 3 having a melting temperature of 280°C and a thickness of 50 µm.

### (Comparative Example 1)

The LCP resin composition of Comparative Example 1 was prepared in the same manner as in Example 1 except that blending of polyarylate was omitted to obtain the LCP film of Comparative Example 1 having a melting temperature of 280°C and a thickness of 50 µm as well as the pressure and heat treated LCP film of Comparative Example 1 having a melting temperature of 280°C and a thickness of 50 µm.

### <Performance Evaluation>

The LCP films of Examples 1 to 3 and Comparative Example 1 as well as the pressure and heat treated LCP films of Examples 1 to 3 and Comparative Example 1 were subjected to performance evaluations. Measurement conditions were as follows.

### [Coefficient of Linear Thermal Expansion]

Measurement device: TMA 4000SE (manufactured by NETZSCH Japan K.K.)
Measurement method: tension mode
Measurement conditions: sample size 20 mm × 4 mm × thickness: 50 µm
   temperature interval: room temperature to 200°C (2nd RUN)
   temperature rising rate: 5°C/min
   atmosphere: nitrogen (flow rate: 50 ml/min)
   test load: 5 gf
      * To observe a value from which the thermal history has been eliminated, the value at 2nd RUN was employed

### [Tensile Modulus]

Measurement device: Strograph VE1D (manufactured by Toyo Seiki Seisaku-sho, Ltd.)
Measurement method: tensile test
Measurement environment: temperature: 23°C, relative humidity: 50%
Measurement conditions: sample size: dumbbell type, thickness: 50 µm
   test speed: 50 mm/min
   marked line distance: 25 mm

### [Relative Dielectric Constant ε_{R}, Dielectric Loss Tangent Tanδ (36 Ghz) Electrical Characteristics]

Measurement method: cylindrical cavity resonator method
Measurement environment: temperature: 23°C, relative humidity: 50%
Measurement conditions: sample size: 15 mm × 15 mm × thickness: 200 µm
cavity: 36 GHz

### [Heat Resistance]

Measurement device: DSC8500 (manufactured by PerkinElmer Japan Co., Ltd.)
Measurement method: differential scanning calorimetry (DSC)
Measurement conditions: temperature interval 30 to 400°C
   1st heating: 20°C/min
   1st cooling: 50°C/min
   2nd heating: 20°C/min

   * * To observe a value from which the thermal history has been eliminated, the value at 2nd RUN was employed

The measurement results are shown in Table 1.

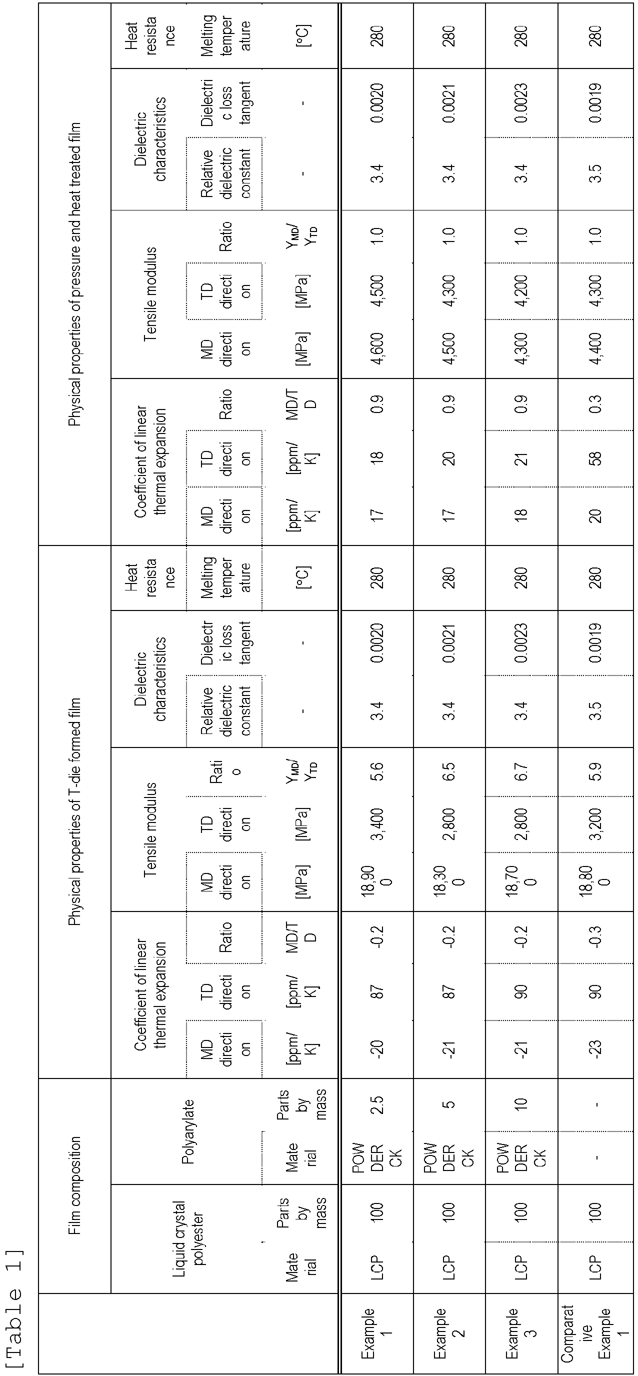

### Industrial Applicability

The LCP film for a circuit substrate of the present invention and the like can be widely and effectively utilized in applications such as electronic circuit substrates, multilayer substrates, high heat radiation substrates, flexible printed wiring boards, antenna substrates, optoelectronic hybrid substrates, and IC packages, and since having especially excellent high frequency characteristics and low dielectric properties, the LCP film for a circuit substrate of the present invention can be especially widely and effectively utilized as an insulating material for flexible printed wiring boards (FPC) and the like in the fifth-generation mobile communication system (5G), millimeter wave radar, and the like.

### Reference Signs List

- 11: LCP film for a circuit substrate
- 11a: Surface
- 11b: Surface
- 21: Metal foil
- 31: Metal foil-clad laminate

### Non-limiting Examples

### [Example 1]

A method for manufacturing an LCP film for a circuit substrate at least comprising:
a composition provision step of providing an LCP resin composition at least containing 100 parts by mass of a liquid crystal polyester and 1 to 20 parts by mass of a polyarylate;
a film forming step of T-die melt-extruding the LCP resin composition to form a T-die melt-extruded LCP film having a coefficient of linear thermal expansion (α2) in a TD direction of 50 ppm/K or more; and
a pressurizing and heating step of subjecting the T-die melt-extruded LCP film to pressure and heat treatment to obtain an LCP film for a circuit substrate having a coefficient of linear thermal expansion (α2) in the TD direction of 16.8 ± 12 ppm/K.

### [Example 2]

The method for manufacturing an LCP film for a circuit substrate according to Example 1, wherein
the T-die melt-extruded LCP film has a ratio of a Young's modulus in an MD direction Y_{MD} to a Young's modulus in the TD direction Y_{TD} (Y_{MD}/Y_{TD}) of 2 or more and 10 or less, and
in the pressurizing and heating step, the T-die melt-extruded LCP film is subjected to pressure and heat treatment to obtain an LCP film for a circuit substrate having a ratio of the Young's modulus in the MD direction Y_{MD} to the Young's modulus in the TD direction Y_{TD} (Y_{MD}/Y_{TD}) of 0.8 or more and 1.5 or less.

### [Example 3]

The method for manufacturing an LCP film for a circuit substrate according to Example 1 or 2, wherein
the T-die melt-extruded LCP film has a thickness of 10 µm or more and 500 µm or less.

### [Example 4]

The method for manufacturing an LCP film for a circuit substrate according to any one of Examples 1 to 3, wherein
in the pressurizing and heating step, the T-die melt-extruded LCP film is subjected to thermocompression bonding while being sandwiched between a pair of endless belts of a double belt press.

### [Example 5]

The method for manufacturing an LCP film for a circuit substrate according to Example 4, wherein
in the pressurizing and heating step, the T-die melt-extruded LCP film is subjected to pressure and heat treatment under the conditions of a surface pressure of 0.5 to 10 MPa and a heating and pressurizing time of 250 to 430°C.

### [Example 6]

The method for manufacturing an LCP film for a circuit substrate according to any one of Examples 1 to 5, wherein
the LCP film for a circuit substrate has a thickness of 10 µm or more and 500 µm or less.

### [Example 7]

The method for manufacturing an LCP film for a circuit substrate according to any one of Examples 1 to 6, wherein
the LCP film for a circuit substrate has dielectric characteristics (36 GHz) of a relative dielectric constant εᵣ of 3.0 to 3.9 and a dielectric loss tangent tanδ of 0.0005 to 0.003.

### [Example 8]

A T-die melt-extruded LCP film for a circuit substrate, comprising at least 100 parts by mass of a liquid crystal polyester and 1 to 20 parts by mass of a polyarylate,
the film having a coefficient of linear thermal expansion (α2) in a TD direction of 16.8 ± 12 ppm/K, and
a thickness of 10 µm or more and 500 µm or less.

### [Example 9]

The T-die melt-extruded LCP film for a circuit substrate according to Example 8, wherein
a ratio of a Young's modulus in an MD direction Y_{MD} to a Young's modulus in the TD direction Y_{TD} (Y_{MD}/Y_{TD}) is 0.8 or more and 1.5 or less.

### [Example 10]

The T-die melt-extruded LCP film for a circuit substrate according to Example 8 or 9, wherein
the film has dielectric characteristics (36 GHz) of a relative dielectric constant εᵣ of 3.0 to 3.9 and a dielectric loss tangent tanδ of 0.0005 to 0.003.

## Claims

1. A T-die melt-extruded LCP film for a circuit substrate, obtainable by a method for manufacturing an LCP film for a circuit substrate, the method at least comprising:
a composition provision step of providing an LCP resin composition at least containing 100 parts by mass of a liquid crystal polyester and 1 to 20 parts by mass of a polyarylate;
a film forming step of T-die melt-extruding the LCP resin composition to form a T-die melt-extruded LCP film having a coefficient of linear thermal expansion (α2) in a TD direction of 50 ppm/K or more; and
a pressurizing and heating step of subjecting the T-die melt-extruded LCP film to pressure and heat treatment to obtain an LCP film for a circuit substrate comprising at least 100 parts by mass of a liquid crystal polyester and 1 to 20 parts by mass of a polyarylate, and having a coefficient of linear thermal expansion (α2) in the TD direction of 16.8 ± 12 ppm/K.

2. The T-die melt-extruded LCP film for a circuit substrate according to claim 1, wherein
a ratio of a Young's modulus in an MD direction Y_{MD} to a Young's modulus in the TD direction Y_{TD} (Y_{MD}/Y_{TD}) is 0.8 or more and 1.5 or less.

3. The T-die melt-extruded LCP film for a circuit substrate according to claim 1 or 2, wherein
the film has dielectric characteristics (36 GHz) of a relative dielectric constant εᵣ of 3.0 to 3.9 and a dielectric loss tangent tanδ of 0.0005 to 0.003.
